# EUROPEAN PATENT APPLICATION

(11) **EP 3 327 949 A1**
(43) Date of publication of application: **30.05.2018**
(21) Application number: 16200677.9
(22) Date of filing: 25.11.2016
(51) Int. Cl.: H04B 7/0417, H03F 1/32, H04B 7/04

(54) **MIMO PRECODING**

(71) Applicant: Alcatel Lucent, 91620 Nozay (FR)
(72) Inventor: GUAN, Lei, Dublin 15 (IE)
(74) Representative: Script IP Limited

(57) **Abstract**

A MIMO precoder, a method and a computer program product are disclosed. The MIMO precoder comprises: a first plurality of digital signal inputs, each operable to receive a corresponding one of a first plurality of digital data streams containing data for transmission to reception equipment; processing logic operable generate a second plurality of precoded digital data streams by performing a digital beamforming function and a digital predistortion function on the first plurality of digital data streams; and a second plurality of signal outputs, each operable to output a corresponding one of the second plurality of precoded digital data streams to a corresponding transceiver for transmission to the reception equipment. In this way, the digital data streams can be precoded to perform both digital beam-forming and digital pre-distortion jointly on the digital data streams so that they can be optimized simultaneously within the processing logic and then each precoded digital data stream provided directly to the transceiver chain which drives an associated antenna element. This provides a scalable arrangement where the precoding can be performed independently of the transceiver chain. This provides for a flexible architecture where the precoding is decoupled from the operation of the transceiver chain and the antenna array, which enables these units to be spatially separated if required. Also, by performing digital pre-distortion, the RF amplifiers can be operated in the non-linear, high efficiency operation region.

## Description

### FIELD OF THE INVENTION

The present invention relates to a MIMO precoder, a method and a computer program product.

### BACKGROUND

Wireless telecommunications networks are known. Base stations in such networks provide wireless connectivity to user equipment within a geographical area or cell, associated with the base station. The wireless communication links between the base station and each of the user equipment typically include one or more downlink (or forward) channels for transmitting information from the base station to the user equipment and one or more uplink (or reverse) channels for transmitting information from the user equipment to the base station.

Multiple-input-multiple-output (MIMO) techniques maybe employed when the base station and the user or other reception equipment include multiple antennas. For example, a base station that includes multiple antennas can transmit multiple independent and distinct signals to user equipment on the same frequency, using the same code and within the same transmission time interval (TTI) which can be resolved by the user equipment.

Although providing MIMO facilitates transmissions within the network, unexpected consequences can occur. Accordingly, it is desired to provide an improved MIMO technique.

### SUMMARY

According to a first aspect, there is provided a MIMO precoder, comprising: a first plurality of digital signal inputs, each operable to receive a corresponding one of a first plurality of digital data streams containing data for transmission to reception equipment; processing logic operable generate a second plurality of precoded digital data streams by performing a digital beamforming function and a digital predistortion function on the first plurality of digital data streams; and a second plurality of signal outputs, each operable to output a corresponding one of the second plurality of precoded digital data streams to a corresponding transceiver for transmission to the reception equipment.

The first aspect recognises that Massive Multiple Input Multiple Output (MIMO) is an important technology for the next generation wireless communications, or 5G (5th Generation) wireless communication systems. The basic concept of massive MIMO is to provide wireless communication services by utilizing a large number of antennas with corresponding transmitters in one go to service multiple users. By using many transmitters at the same site (centralized) or at different sites (distributed), the network capacity and data throughput can be significantly increased, providing better services for more users.

In a practical massive MIMO system, in order to provide reasonable radiating power from each transmitter to the surrounding space, a radio frequency (RF) power amplifier is required in each transmitter. The power efficiency of RF power amplifiers will significantly affect the overall system performance regarding the energy consumption, so it is desirable to drive the RF power amplifiers into a high-efficiency operation region. However, the RF power amplifiers are inherently nonlinear at the high-efficiency operation region, in other words, RF power amplifiers introduce nonlinear distortion into the signal causing both in-band signal quality degradation (which causes problems to the transmitter itself) and out-of-band spectrum regrowth (which causes problems to others transmitters working in adjacent frequency bands). Traditionally, RF engineers would back-off the power to let the RF power amplifiers work in the linear operation region. However, this back-off approach leads to very low power efficiency. Due to its satisfactory linearization performance and flexibility, digital predistortion (DPD) can be used to reduce/ eliminate the nonlinear distortion introduced by the RF power amplifiers.

In a massive MIMO system, beamforming (BF) technology is used to shape the spatial radiating patterns and form several energy-concentrated beams to serve multiple areas. This function can be achieved both in the analogue and the digital domains. As the cost of digital resources, like silicon devices, is getting lower and lower year by year, flexible digital beamforming (DBF) would be a desirable option. Digital beam-forming technology introduces digital weighting functions into the baseband of multiple transmission (TX) branches, so that the phase and amplitude (power) of different TX branches will be modified according to the DBF requirement. By using appropriate weights, the antenna radiating patterns will be steered correspondingly towards to the interested area.

However, in order to successfully deploy massive MIMO base-stations with satisfactory performance, the massive MIMO system needs to be designed with consideration of both the digital spatial multiplexing requirement (for multiple beams) and RF signal conditioning requirement (for interference control for self and others).

Accordingly, a precoder is provided. The precoder may be for a Multiple Input Multiple Output antenna driver. The precoder may comprise a plurality of inputs. Each of the inputs may be configured to receive a corresponding digital signal stream which contains or encodes data for transmission to reception equipment. That is to say, each input to the precoder receives its own digital data stream. The precoder may also comprise processing logic which generates or encodes a plurality of precoded digital data streams. The precoded digital data streams may be generated or encoded by performing or executing a digital beam-forming function or operation together with a digital pre-distortion function or operation on the plurality of digital data streams. The precoder may also comprise another plurality of signal outputs. Each of the outputs may provide one of the precoded digital data streams. Each precoded data stream may be provided to a corresponding transceiver for transmission to the reception equipment. In this way, the digital data streams can be precoded to perform both digital beam-forming and digital pre-distortion jointly on the digital data streams so that they can be optimized simultaneously within the processing logic and then each precoded digital data stream provided directly to the transceiver chain which drives an associated antenna element. This provides a scalable arrangement where the precoding can be performed independently of the transceiver chain. This provides for a flexible architecture where the precoding is decoupled from the operation of the transceiver chain and the antenna array, which enables these units to be spatially separated if required. Also, by performing digital pre-distortion, the RF amplifiers can be operated in the non-linear, high efficiency operation region.

In one embodiment, the second plurality is greater than the first plurality. Accordingly, more precoded digital data streams may be output than the number of digital data streams, in order to drive a large antenna array.

In one embodiment, the digital data streams are encoded at a first sampling rate and the precoded digital data streams are encoded at a second sampling rate. Accordingly, the precoded digital data streams may be provided at a different sampling rate than the sampling rate of the digital data streams.

In one embodiment, the second sampling rate is higher than the first sampling rate. Accordingly, the precoded digital data streams may be provided at an RF frequency, whereas the digital data streams may be provided at a base band frequency.

In one embodiment, the processing logic comprises a linear filter operable to perform the digital beamforming function by applying linear filtering to each of the first plurality of digital data streams. Accordingly, the linear filtering may be performed in order to provide the digital beamforming function or operation.

In one embodiment, the processing logic comprises a non-linear filter operable to perform the digital predistortion function to generate the second plurality of precoded digital data streams by applying non-linear filtering. Accordingly, non-linear filtering may be performed in order to provide the digital pre-distortion function or operation and generate the precoded digital data streams.

In one embodiment, the linear filter is operable to generate a second plurality of intermediate digital data streams at the first sampling rate and the processing logic comprises upconversion logic operable to upconvert the second plurality of intermediate digital data streams to the second sampling rate and the non-linear filter is operable to generate the second plurality of precoded digital data streams at the second sampling rate from the second plurality of intermediate digital data streams. Accordingly, the processing logic may generate intermediate digital data streams which are upconverted or upsampled from the first sampling rate to the second sampling rate. The linear filter may operate at the first sampling rate, while the non-linear filter may operate at the second sampling rate.

In one embodiment, the linear filter comprises a plurality of linear sub-filters, each of which receives each of the first plurality of digital data streams, performs frequency dependent beamforming by applying a corresponding linear filter having a corresponding set of linear filter coefficients to each of the first plurality of digital data streams to generate a corresponding linear filtered digital data stream and combines the linear filtered digital data streams to generate a corresponding one of the intermediate digital data streams. Accordingly, every linear sub-filter may receive every digital data stream and perform linear filtering with its own set of filter coefficients; each linear filtered digital data stream generated by a sub-filter may then combined to generate one of the intermediate digital data streams.

In one embodiment, the non-linear filter comprises a plurality of non-linear sub-filters, each of which receives one of the intermediate digital data streams, performs frequency independent non-linear filtering by applying a corresponding non-linear filter having a corresponding set of non-linear filter coefficients to the one of the intermediate digital data streams to generate a corresponding one of the second plurality of precoded digital data streams. Accordingly, a plurality of non-linear sub-filters may be provided. Each non-linear sub-filter may receive one of the intermediate digital data streams and generate one of the precoded digital data streams.

In one embodiment, the processing logic comprises coefficient calculation logic operable to generate a set of linear filter coefficients for each linear sub-filter which maximise reception of the data by the reception equipment. Accordingly, all the linear coefficients may be generated by the coefficient calculation logic. Typically, the coefficients are calculated to minimize the out-of-band emission, which reduces the interference for adjacent band users and improves the in-band signal quality.

In one embodiment, the processing logic comprises coefficient calculation logic operable to generate a set of non-linear filter coefficients for each non-linear sub-filters which maximise reception of the data by the reception equipment. Accordingly, the coefficient calculation logic may also generate a set of non-linear filter coefficients for each non-linear sub-filter which also maximises reception of data by the reception equipment.

In one embodiment, the coefficient calculation logic is operable to receive an indication of reception of the data by the reception equipment. Accordingly, an indication may be provided which indicates interference experienced by the reception equipment and/or the quality of data received by the reception equipment as feedback for use when generating the filter coefficients.

According to a second aspect, there is provided a method, comprising: receiving a first plurality of digital data streams containing data for transmission to reception equipment at a first plurality of digital signal inputs; generating a second plurality of precoded digital data streams by performing a digital beamforming function and a digital predistortion function on the first plurality of digital data streams; and outputting the second plurality of precoded digital data streams to a second plurality of signal outputs to a corresponding transceiver for transmission to the reception equipment.

In one embodiment, the second plurality is greater than the first plurality.

In one embodiment, the digital data streams are encoded at a first sampling rate and the precoded digital data streams are encoded at a second sampling rate.

In one embodiment, the second sampling rate is higher than the first sampling rate.

In one embodiment, the method comprises performing the digital beamforming by applying linear filtering to each of the first plurality of digital data streams.

In one embodiment, the method comprises performing the digital predistortion function to generate the second plurality of precoded digital data streams by applying non-linear filtering.

In one embodiment, the method comprises generating a second plurality of intermediate digital data streams at the first sampling rate, upconverting the second plurality of intermediate digital data streams to the second sampling rate and generating the second plurality of precoded digital data streams at the second sampling rate from the second plurality of intermediate digital data streams.

In one embodiment, the method comprises receiving of the first plurality of digital data streams at each of a plurality of linear sub-filters, performing frequency dependent beamforming by applying a corresponding linear filter having a corresponding set of linear filter coefficients to each of the first plurality of digital data streams to generate a corresponding linear filtered digital data stream and combining the linear filtered digital data streams to generate a corresponding one of the intermediate digital data streams.

In one embodiment, the method comprises receiving one of the intermediate digital data streams at a corresponding one of a plurality of non-linear sub-filters and performing frequency independent non-linear filtering by applying a corresponding non-linear filter having a corresponding set of non-linear filter coefficients to the one of the intermediate digital data streams to generate a corresponding one of the second plurality of precoded digital data streams.

In one embodiment, the method comprises generating a set of linear filter coefficients for each linear sub-filter which maximises reception of the data by the reception equipment.

In one embodiment, the method comprises generating a set of non-linear filter coefficients for each non-linear sub-filters which maximises reception of the data by the reception equipment.

In one embodiment, the method comprises receiving an indication of reception of the data by the reception equipment.

According to a third aspect, there is provided a computer program product operable, when executed on a computer, to perform the method steps of the second aspect.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates an arrangement having conventional DPD and DBF units;
Figure 2 illustrates DPD and DBF optimization;
Figure 3 is a block diagram of a DPD and DBF separated system architecture for massive MIMO;
Figure 4 shows an embodiment where the DBF and DPD are integrated into a single unit in the digital domain; and
Figure 5 illustrates the DBF & DPD integrated weight module in more detail.

### DESCRIPTION OF THE EMBODIMENTS

Before discussing the embodiments in any more detail, first an overview will be provided. Embodiments provide an architecture for use in MIMO wireless telecommunications networks. In particular, a precoder is provided which receives baseband digital data streams which contain the data to be transmitted to reception equipment (such as user equipment like mobile phones, tablets or the like), or to base stations (such as small cell base stations, femto base stations or the like). Processing logic takes the received digital data streams and performs both a digital beam-forming function or operation together with a digital pre-distortion function or operation on the digital data streams and generates a number of precoded digital data streams. Those precoded digital data streams can then be provided directly to transceiver chains which drive each antenna element within the MIMO antenna array. This enables the power amplifiers driving the antenna elements to be operated in their efficient non-linear region, while also providing for design flexibility over the spatial location of the components used to drive the antennas.

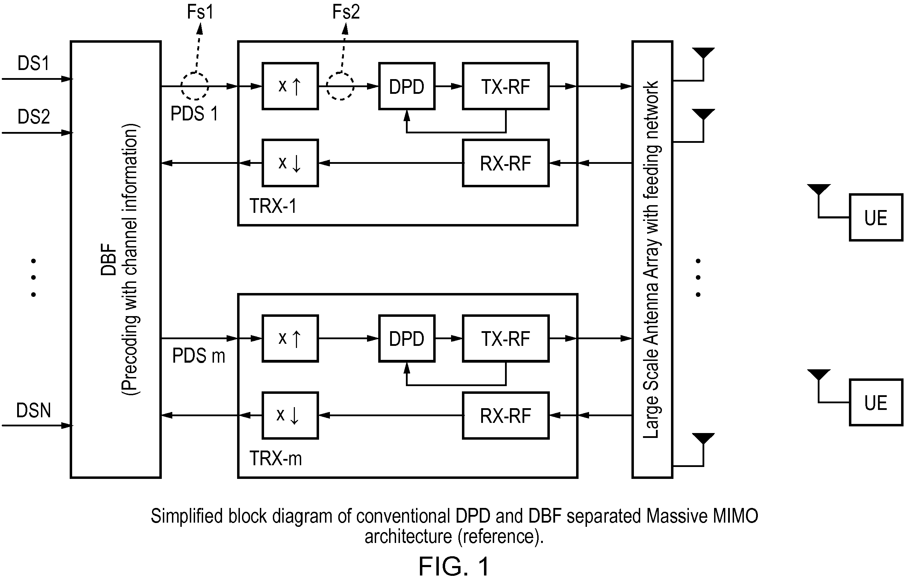

By way of background, Figure 1 illustrates an arrangement where conventional DPD and DBF units are treated as two signal-processing functions that are rotating (phase modification) and scaling (amplitude modification) the complex IQ signals in the digital domain, and those two digital functions are working separately at different sampling rates. For example, given a 10MHz LTE signal in 4G wireless system, the sampling rate Fs1 is 15.36MSPS, while Fs2 is usually much higher than baseband processing rate, which is helpful to increase the frequency dynamic range. Depending on the requirement of RF-front end, Fs2 could be multiples of Fs1, such as 61.44MSPS, 122.88MSPS, 245.76MSPS, etc.

In Figure 1, DS represents the data stream and PDS represents the precoded data stream. For illustration, a full-size massive MIMO is shown, i.e., the number of TRXs are much larger than the number of processed data streams, namely, M >> N.

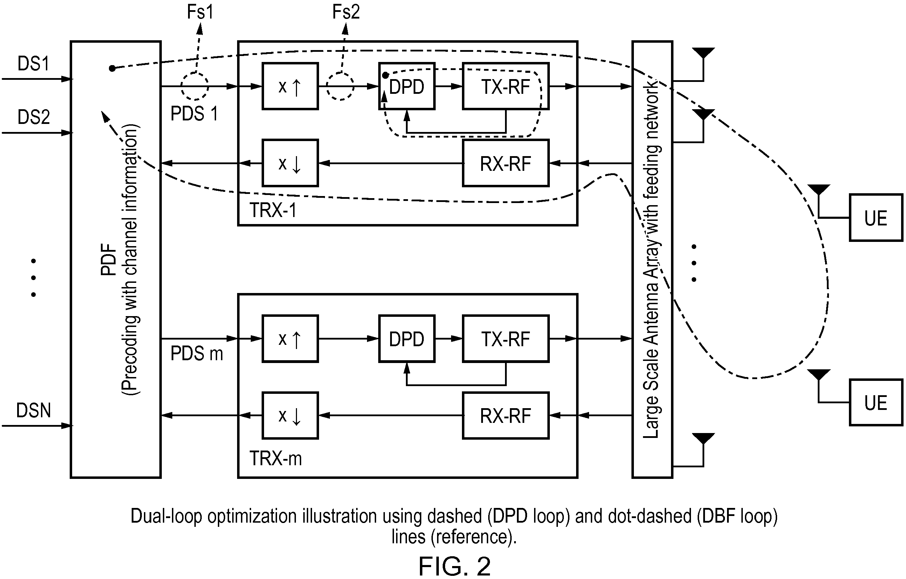

However, this conventional system design approach doesn't provide a cost-effective and performance-enhanced massive MIMO solution, because it only optimizes a single functional box at one time. For example, DPD is a relatively-short, closed-loop optimization, while channel-aware DBF is a long, closed-loop optimization as shown in Figure 2. The dot circle is DPD loop, while the dash dot circle is beamforming loop.

Embodiments provide a single-loop solution that combines coefficients extraction processes for both DPD and DBF into a single block in the digital domain (typically in the cloud-RAN environment). In other words, embodiments utilise a joint DBF and DPD approach, which includes the function of DPD and the function of DBF simultaneously.

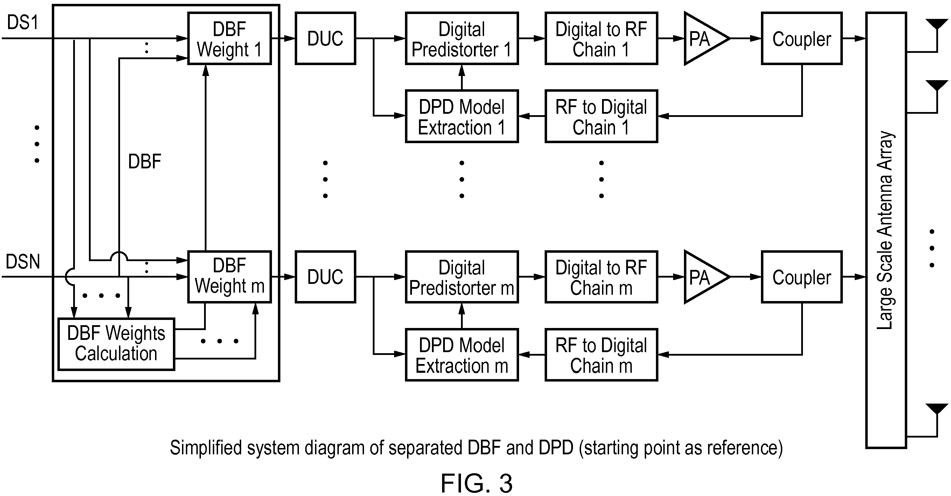

Figure 3 shows a block diagram of a DPD and DBF separated system architecture for massive MIMO, which is used as a reference to illustrate an example of a direct (non-optimal) system architecture with separated DPD and DBF functions.

This architecture includes: a Digital Beam Forming Weights Calculation Unit, Digital Predistorter Units, DPD Model Extraction Units, Digital Upconversion modules (DUC), Digital to RF Chains, RF to Digital Chains, Power Amplifiers, Couplers and a Large Scale Antenna Array.

The DBF Weights Calculation Unit is used for calculating the complex weights for steering the antenna beams. The DBF can either open loop-based or closed loop-based. The open loop-based DBF doesn't need any channel information, and it provides antenna beams steering to a pre-targeted area with pre-defined beam characteristics; while the closed loop-based DBF requires up-to-date channel information to optimize the weighting coefficients for particular channel states. The DBF weight unit is a linear-filter like function, which is used for rotating and scaling the signal according to the derived DBF weights.

The Digital Upconversion Module is used for upsampling the baseband precoded data streams from Fs1 to Fs2.

The Digital Predistorter Unit has a nonlinear-filter like function to pre-distort the signal to improve the linearity at the RF power amplifiers' outputs.

The DPD Model Extraction Unit is utilized for calculating/estimating DPD coefficients to minimize some pre-defined cost functions.

The Digital to RF Chain is required for up-converting the baseband signals to the RF carrier frequency. In general, it contains Digital to Analog Convertors (DACs), quadrature Modulation, anti-image filters, a local oscillator and a frequency mixer.

The Power Amplifier is needed for increasing the signal power, and it is inherently nonlinear when it is pushed to the high-efficiency operation zone.

The RF to Digital Chain is often referred to as a sampling receiver or observation receiver, which includes a local oscillator, a frequency mixer, an anti-aliasing filter, and Analog to Digital Convertors (ADCs).

The Coupler is used to couple a small amount of the high power transmitter signal back to the observation path.

The Large Scale Antenna Array has many antenna elements for radiating an aggregated (beamformed) signal into the space pointing to the targeting areas.

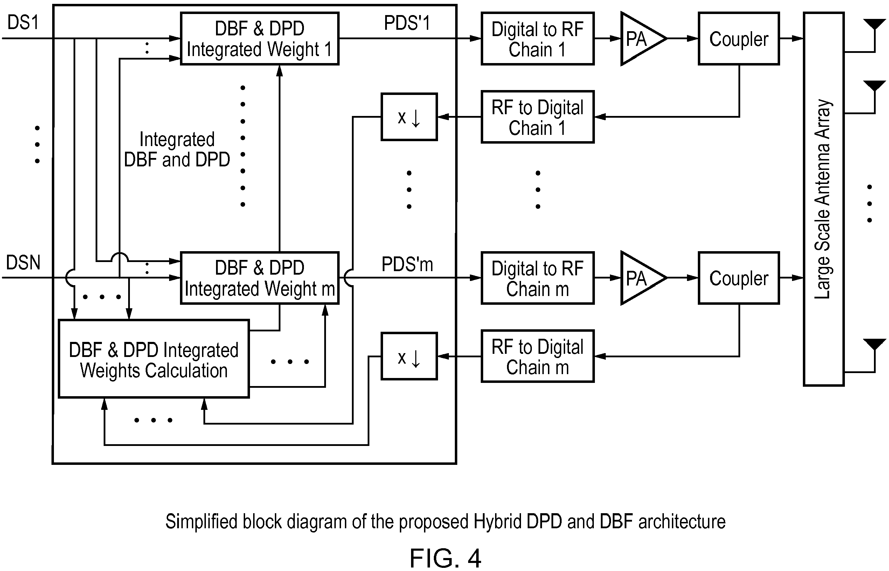

Figure 4 shows an embodiment where the DBF and DPD are integrated into a single unit in the digital domain (for example, cloud-RAN based or virtualized baseband processing pool based) for both the forward data path and the weight calculation path.

This architecture includes a DBF &DPD Integrated Weights Calculation Unit, DBF & DPD Integrated Weights units, downsampling modules (×↓), Digital to RF Chains, Power Amplifiers, RF to Digital Chains, Couplers and a Large Scale Antenna Array.

Two derived architectures can be formed, depending on the requirement of beamforming (either open-loop with channel information, or closed-loop with channel information). The open-loop arrangement is shown, in the closed-loop arrangement, reception feedback is provided from the user equipment via the large scale antenna array.

The main distinguished functions with respect to the reference architecture (shown in Figure 3) are as follows.

The DBF &DPD Integrated Weights Calculation Unit, which is used to derive a set of coefficients for each transmission branch by optimizing a joint cost function regarding both the DBF requirement and the DPD requirement at baseband sampling rate; for example, given a 10MHz LTE signal, the sampling rate will be 15.36MSPS. Using this approach, the DPD parameter-related extraction part is operating in an undersampled manner (compared to the conventional high sampling rate DPD), while the DBF parameter-related extraction part is operating at a normal baseband processing rate. Particularly, those two extraction parts have the same sampling rate, and can be calculated together.

The DBF &DPD Integrated Weights units: these units utilize a nonlinear model to describe the nonlinear behavior between the original input signal and the RF power amplifier's output signal with embedded consideration of DBF functions at the baseband sampling rate; DBF is a linear filter, and DPD is a nonlinear filter, if we combine those two into consideration, it is a nonlinear filter from system level point view. Each DBF &DPD Integrated Weights unit receives the baseband signals Ds1 to DSN, performs filtering in accordance with the weights provided from the DBF &DPD Integrated Weights Calculation Unit and outputs a precoded data stream PDS'1; PDS'N to its transmission chain.

The Downsampling modules are used to downsample the feedback signal from the higher sampling rate, Fs2 to the baseband sampling rate, Fs1. This is not a conventional decimate filter for digital down-conversion, as we need the aliasing signal to build undersampled DPD using fewer terms to cover the longer memory effects.

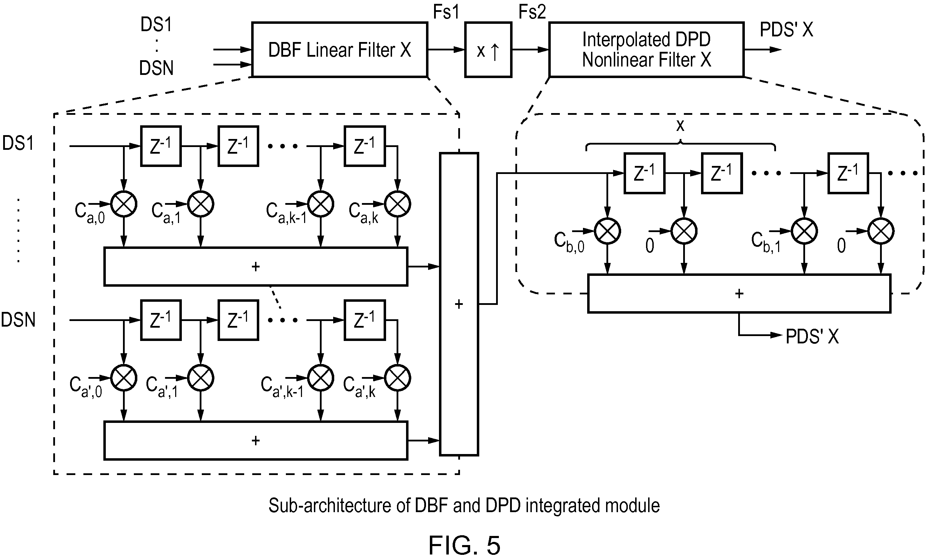

The DBF & DPD integrated weight module is illustrated in more detail shown in Figure 5. Embodiments only use memory related terms to illustrate the interpolated DPD nonlinear filtering approach, since only memory terms are associated with sampling rate modification. As mentioned above, the weights C are provided by the DBF & DPD Integrated Weights Calculation Unit.

Embodiments enable a cost-effective and performance-enhanced active antenna array front-end by using a jointly-optimized Digital beamforming (DBF) and undersampled digital predistortion (DPD) approach. Embodiments provide a software-defined component in cloud-RAN based virtualized base-station architecture, especially an edge-cloud computing feature. In network slicing applications, embodiments enable a flexible re-configurable massive MIMO based solution, which provides a soft-sector capability with optimized performance.

Compared to the conventional DBF and DPD separated solution, embodiments provide the following advantages: Embodiments provide a compact, undersampled DPD approach, which reduces the complexity of linearization processing; The joint DBF and DPD approach takes both the spatial multiplexing requirement and the linearity requirement into consideration to build an efficient phase and amplitude weighting module, which enhances the system-level performance; Embodiments are well-suited to cloud-based virtualized base-station architecture, especially the edge-cloud with massive MIMO active antenna array as wireless access equipment; Embodiments provide a software defined network component module, which can be easily updated and adapted for re-configurable massive MIMO applications.

Embodiments provide a joint DBF and DPD estimation architecture which ensure the linear operation of the massive MIMO TX chains with proper spatial multiplexing, and improve the system efficiency with significantly reduced system complexity and cost.

It will be appreciated that embodiments are suitable for re-configurable massive MIMO applications, such as creating several soft-sectors to steer multiple beams for multiple areas at multiple time periods. For example, a very busy stadium in the afternoon will be very quiet during the night; embodiments can generate a soft-sector to cover this stadium when there is a game, and steered to other places when the stadium is empty by weight adjustment.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A MIMO precoder, comprising:
a first plurality of digital signal inputs, each operable to receive a corresponding one of a first plurality of digital data streams containing data for transmission to reception equipment;
processing logic operable generate a second plurality of precoded digital data streams by performing a digital beamforming function and a digital predistortion function on said first plurality of digital data streams; and
a second plurality of signal outputs, each operable to output a corresponding one of said second plurality of precoded digital data streams to a corresponding transceiver for transmission to said reception equipment.

2. The MIMO precoder of claim 1, wherein said second plurality is greater than said first plurality.

3. The MIMO precoder of claim 1 or 2, wherein said digital data streams are encoded at a first sampling rate and said precoded digital data streams are encoded at a second sampling rate.

4. The MIMO precoder of claim 3, wherein said second sampling rate is higher than said first sampling rate.

5. The MIMO precoder of any preceding claim, wherein said processing logic comprises a linear filter operable to perform said digital beamforming function by applying linear filtering to each of said first plurality of digital data streams.

6. The MIMO precoder of any preceding claim, wherein said processing logic comprises a non-linear filter operable to perform said digital predistortion function to generate said second plurality of precoded digital data streams by applying non-linear filtering.

7. The MIMO precoder of claim 6, wherein said linear filter is operable to generate a second plurality of intermediate digital data streams at said first sampling rate and said processing logic comprises upconversion logic operable to upconvert said second plurality of intermediate digital data streams to said second sampling rate and said non-linear filter is operable to generate said second plurality of precoded digital data streams at said second sampling rate from said second plurality of intermediate digital data streams.

8. The MIMO precoder of any one of claims 5 to 7, wherein said linear filter comprises a plurality of linear sub-filters, each of which receives each of said first plurality of digital data streams, performs frequency dependent beamforming by applying a corresponding linear filter having a corresponding set of linear filter coefficients to each of said first plurality of digital data streams to generate a corresponding linear filtered digital data stream and combines said linear filtered digital data streams to generate a corresponding one of said intermediate digital data streams.

9. The MIMO precoder of any one of claims 6 to 8, wherein said non-linear filter comprises a plurality of non-linear sub-filters, each of which receives one of said intermediate digital data streams, performs frequency independent non-linear filtering by applying a corresponding non-linear filter having a corresponding set of non-linear filter coefficients to said one of said intermediate digital data streams to generate a corresponding one of said second plurality of precoded digital data streams.

10. The MIMO precoder of claim 8 or 9, wherein said processing logic comprises coefficient calculation logic operable to generate a set of linear filter coefficients for each linear sub-filter which maximise reception of said data by said reception equipment.

11. The MIMO precoder of claim 9 or 10, wherein said processing logic comprises coefficient calculation logic operable to generate a set of non-linear filter coefficients for each non-linear sub-filters which maximise reception of said data by said reception equipment.

12. The MIMO precoder of claim 11, wherein said coefficient calculation logic is operable to receive an indication of reception of said data by said reception equipment.

13. A method, comprising:
receiving a first plurality of digital data streams containing data for transmission to reception equipment at a first plurality of digital signal inputs;
generating a second plurality of precoded digital data streams by performing a digital beamforming function and a digital predistortion function on said first plurality of digital data streams; and
outputting said second plurality of precoded digital data streams to a second plurality of signal outputs to a corresponding transceiver for transmission to said reception equipment.

14. A computer program product operable, when executed on a computer, to perform the method of claim 13.
